Europäisches Patentamt

European Patent Office

Office européen des brevets

(11) Publication number: **0 514 873 A1**

## EUROPEAN PATENT APPLICATION

(21) Application number: **92108529.6**

(22) Date of filing: **20.05.92**

(51) Int. Cl.5: **H01L 23/34**, G01N 27/417

(30) Priority: **24.05.91 JP 222540/91**

(43) Date of publication of application:
**25.11.92 Bulletin 92/48**

(84) Designated Contracting States:
**DE FR GB**

(71) Applicant: **HONDA GIKEN KOGYO KABUSHIKI KAISHA**
**1-1, 2-chome Minami-Aoyama**
**Minato-ku Tokyo(JP)**

(72) Inventor: **Inaba, Atsushi**
**c/o K.K. Honda Gijyutsu Kenkyusho, 4-1, 1-chome**
**Chuo, Wako-shi, Saitama(JP)**

(74) Representative: **Fincke, Karl Theodor, Dipl.-Phys. Dr. et al**
**Patentanwälte H. Weickmann, Dr. K. Fincke F.A. Weickmann, B. Huber Dr. H. Liska, Dr. J. Prechtel, Dr. B. Böhm, Kopernikusstrasse 9 W-8000 München 86(DE)**

(54) **Heater type hybrid integrated circuit.**

(57) Disclosed is a heater type hybrid integrated circuit wherein a circuit pattern is directly formed on a surface of a ceramic heater (3) consisting of a ceramic substrate (1) containing therein a heater element (2), without using any separate circuit board, and a sensor element (6) and necessary sensor circuit components (7,8) are mounted in the above-mentioned circuit pattern.

FIG. 1

## BACKGROUND OF THE INVENTION

The present invention relates to a heater type hybrid integrated circuit consisting of a circuit pattern directly formed on a surface of a ceramic substrate with a heater embedded therein.

A conventional oxygen sensor which, for example, operates on the principle of the oxygen concentration cell, has a sensing element to be forcibly heated since it may have better electromotive force characteristics at elevated temperatures of 500 to $700^0$ C. In Fig. 3, an oxygen sensor 4, which is disclosed in Japanese laid open patent publication No. 94258/81, consists of a standard electrode layer 41, solid electrolyte layer 42 and measuring electrode layer 43 may be directly formed on a ceramic heater 3 composed of a ceramic substrate 1 and a heater 2 embedded therein.

However, the above-mentioned oxygen sensor requires to be equipped with a separate circuit for amplifying the sensor's output signal, wherein the measurement accuracy may be reduced due to the possible temperature drift.

Recently, as known from Japanese laid open patent publication No. 29858/91, a gas flow type semiconductor angular velocity sensor has been developed for determining a degree of gas flow deflection by the action of angular velocity on the sensor body by means of a pair of heat wires having a temperature-sensitive resistance, wherein a gas path and a nozzle hole for forcing gas into the gas path are formed on semiconductor substrates by semiconductor technology, a pair of heat wires is also formed on the semiconductor substrates and then a miniature pump drivable by a piezoelectric element is compactly formed on the semiconductor substrate by applying IC technology.

Since the above-mentioned gas type angular velocity sensor is intended to detect a magnitude of angular velocity acting on the sensor body from a change of temperature-sensitive resistance of paired heat wires when the heat wires being exposed to the gas flow, it is needed to forcibly heat the sensor by a heater to be kept at a constant ambient temperature for protection against the exterior temperature affection.

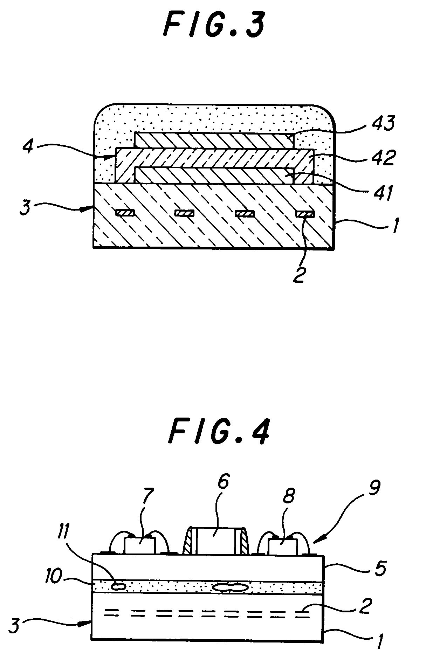

For the above-mentioned reason, the prior art provides that, as shown in Fig. 4, a circuit pattern consisting of a sensor circuit and a sensor output signal amplifier circuit including resistances and wirings are formed on a circuit substrate 5 and a sensing element 6 of the semiconductor gas flow type angular velocity sensor and the circuit elements 7, 8 necessary for the amplifier circuit are mounted in the corresponding portion of the circuit pattern to form a hybrid integrated circuit portion 9, and then the circuit substrate 5 with the circuit portion 9 mounted therein is bonded to a ceramic heater 3 composed of a ceramic substrate 1 and a heating element 2 embedded therein. Numeral 10 designates a layer of adhesive for bonding the circuit substrate to the ceramic heater 3.

However, the above-mentioned arrangement has such a drawbacks that the existence of circuit substrate 5 and the adhesion layer 10 between ceramic heater 3 and circuit portion 9 reduces thermal conductivity and affects temperature rising characteristic at heating start, and allocation of many components makes the whole unit correspondingly larger in size.

Furthermore, if there is a void 11 in the adhesive layer 10, heat energy generated by the ceramic heater 3 can not be transferred evenly in the circuit portion 9, resulting in nonuniform heating of the circuit portion.

The problems of the prior art are as follows:

When the sensor circuit and the sensor output amplifier are provided separately from sensing element mounted on the ceramic heater consisting of a heater embedded in a ceramic substrate, the temperature drift can be caused, resulting in lowering the detection accuracy of the sensor.

Furthermore, when a circuit substrate with a hybrid IC type circuit portion formed thereon is bonded to a ceramic heater, a thermal conductivity may be lowered and whole sensor must have a large size.

## SUMMARY OF THE INVENTION

In view of the foregoing, the present invention was made to provide a heat type hybrid integrated circuit wherein a circuit pattern is directly formed on a surface of a ceramic substrate containing a heater with no separate circuit substrate, and a sensing element and necessary sensor circuit components are placed on the directly formed circuit pattern.

## BRIEF DESCRIPTION OF DRAWINGS

Fig. 1 is a front view showing an example of a heater type hybrid integrated circuit embodying the present invention.

Fig. 2 is a front view of another example of a heater type hybrid integrated circuit embodying the present invention.

Fig. 3 is a front sectional view showing a conventional oxygen sensor formed on a ceramic heater.

Fig. 4 is a front view showing a conventional heater type integrated circuit.

In the drawings, 1 is a ceramic substrate, 2 is a heater, 3 is a ceramic heater, 6 is a gas flow type semiconductor angular velocity sensor and 9 is a circuit portion.

## DESCRIPTION OF THE PREFERRED EMBODIMENTS

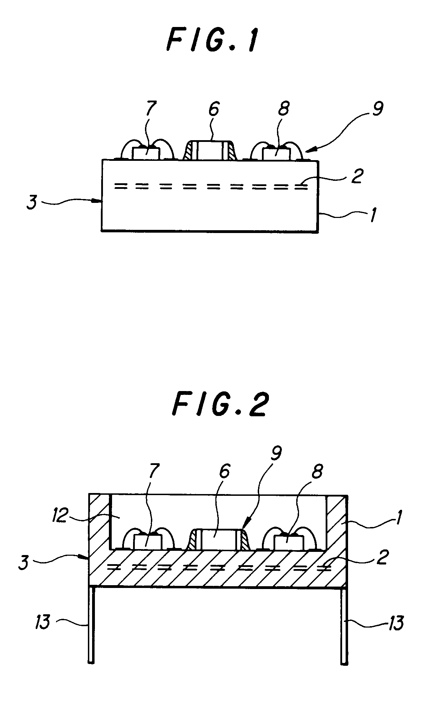

Fig. 1 shows an example of a heater type hybrid integrated circuit embodying the present invention, which comprises a ceramic heater 3 having heating elements 2 embedded in a ceramic substrate 1 and a hybrid IC type circuit portion 9 containing a sensor circuit and a sensor output amplifier circuit pattern consisting of resistances and wirings formed directly on the ceramic heater 3 with a gas flow type semiconductor angular velocity sensor element 6 and necessary amplifier circuit components 7, 8 mounted therein.

The sensor circuit is composed of a resistance bridge circuit containing a pair of heat wires and a standard resistance for the gas flow type angular velocity sensor element 6.

Fig. 2 shows another embodiment of the present invention, wherein a circuit portion 9 is packaged in a concaved portion 12 of a ceramic substrate 1. In Fig. 2, numeral 13 designates lead wires of a heater 2, which is drawn out from a ceramic substrate 1.

When a ceramic substrate 1 is made of 98% aluminum ceramic, it is possible to form thereon a circuit pattern by thick-film printing method. But in case of the ceramic substrate made of 92% aluminum ceramic it is hard to form thereon a circuit pattern by the thick-film printing method. In this case a circuit pattern must be formed on the ceramic substrate 1 only by evaporating or plating.

As described above, in the heater type hybrid integrated circuit according to the present invention, the sensor circuit of the gas flow type semiconductor sensing element 6 and the sensor output amplifier circuit are integrally formed on the ceramic heater 3, thereby the temperature drift problem may not be caused and a high accuracy sensor output signal can be obtained.

According to the present invention, the ceramic heater 3 serves itself as a ceramic substrate (without using a separate circuit substrate used in the conventional device), thereby none of circuit substrate and bonding layer exists between the ceramic heater 3 and the circuit portion 9, the thermal conductivity is improved and the temperature rising characteristic at heating start is also improved. In addition, a space between the heater 2 and the circuit portion 9 is reduced to about 1/2 in comparison with that of conventional device. This means the possibility of reducing the necessary energy consumption of the heater 2.

According to the present invention, nothing lies between the ceramic heater 3 and the circuit portion 9, thereby the possibility of nonuniformly heating is eliminated and heat energy generated by the heater 2 can be transferred evenly in the circuit portion 9.

Furthermore, according to the present invention, the hybrid type integrated circuit may be simplified in construction and effectively miniaturized. Further size reduction of the circuit can also be effected by mounting circuit elements on both planes of the heater 2.

While the above-mentioned embodiment employs a gas flow type semiconductor angular velocity sensing element 6 as a sensor, it is not intended that the invention be limited to the shown embodiment. An oxygen sensor and other sensors requiring temperature control by forcibly heating may be also employed.

As is apparent from the foregoing description, according to the present invention, it is possible to provide a heater type hybrid integrated circuit wherein a circuit pattern is directly formed on a ceramic substrate containing therein a heater and then a sensor element and necessary circuit elements are mounted in the circuit pattern, and which offers such advantages that thermal energy generated by the heater can be effectively transferred in the circuit portion without causing a temperature drift and thereby a highly accurate output signal of the sensor can be obtained; and that whole circuit structure can be simplified and have a reduced size.

## Claims

1. A heater type hybrid integrated circuit comprising a circuit pattern directly formed on a surface of a ceramic substrate containing therein a heater.

2. A heater type hybrid integrated circuit according to claim 1, characterized in that a sensor element and a circuit element necessary for said sensor element are arranged on the circuit pattern directly formed on the ceramic substrate surface.

FIG.1

FIG.2

# FIG.3

# FIG.4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | GB-A-1 187 595 (TELEFUNKEN)<br>* the whole document * | 1 | H01L23/34<br>G01N27/417 |
| Y | | 2 | |
| | --- | | |
| D,Y | PATENT ABSTRACTS OF JAPAN<br>vol. 15, no. 162 (P-1194)23 April 1991<br>& JP-A-3 029 858 ( HONDA ) 7 February 1991<br>* abstract * | 2 | |
| | --- | | |
| A | PATENT ABSTRACTS OF JAPAN<br>vol. 11, no. 165 (E-510)27 May 1987<br>& JP-A-62 001 256 ( SONY TEKTRONIX ) 7 January 1987<br>* abstract * | 1,2 | |
| | --- | | |
| A | PATENT ABSTRACTS OF JAPAN<br>vol. 11, no. 117 (E-498)11 April 1987<br>& JP-A-61 264 744 ( TOSHIBA ) 22 November 1986<br>* abstract * | 1,2 | |
| | --- | | |
| A | PATENT ABSTRACTS OF JAPAN<br>vol. 15, no. 153 (P-1191)17 April 1991<br>& JP-A-3 024 450 ( BROTHER ) 1 February 1991<br>* abstract * | 1,2 | TECHNICAL FIELDS SEARCHED (Int. Cl.5 )<br><br>H01L<br>G01N |
| | --- | | |
| A | PATENT ABSTRACTS OF JAPAN<br>vol. 8, no. 181 (E-261)21 August 1984<br>& JP-A-59 072 750 ( MATSUSHITA ) 24 April 1984<br>* abstract * | 1-2 | |

-----

The present search report has been drawn up for all claims

| Place of search | Date of completion of the search | Examiner |
|---|---|---|
| BERLIN | 21 AUGUST 1992 | MUNNIX S. |

EPO FORM 1503 03.82 (P0401)